# EUROPEAN PATENT APPLICATION

(11) **EP 4 604 395 A1**
(43) Date of publication of application: **20.08.2025**
(21) Application number: 25158080.9
(22) Date of filing: 14.02.2025
(51) Int. Cl.: H03K 17/691, H03B 5/12

(54) **ISOLATION DEVICE HAVING INDUCTIVE AND CAPACITIVE ISOLATION CIRCUIT**

(30) Priority: 15.02.2024 US 202418442322
(71) Applicant: Littelfuse, Inc., Rosemont, Illinois 60018 (US)
(72) Inventor: EGURROLA, Daniel, Rosemont, 60018 (US); MARTINEZ, Cesar, Rosemont, 60018 (US)
(74) Representative: Arnold & Siedsma

(57) **Abstract**

An isolation circuit arrangement may include an isolation barrier and may be configured to receive one or more input signals on a low voltage side and deliver one or more output signals on a high voltage side. The isolation barrier may include a first capacitor, arranged along a first input line, a second capacitor arranged along a second input line, electrically parallel to the first capacitor, and a first inductor having a first end that is coupled to a first electrode of the first capacitor and having a second end that is coupled to a first electrode of the second capacitor. The isolation barrier may further include a center tap, connected to the first inductor, and a second inductor that is inductively coupled to the first inductor and is arranged with a first output end and a second output end on a high voltage side of the isolation circuit arrangement.

## Description

### Background

### Field

Embodiments relate to the field of circuit protection devices, including, isolated gate drivers and digital isolators.

### Discussion of Related Art

An insulated gate bipolar transistor (IGBT) or power metal oxide semiconductor field effect transistor (MOSFET) each represent a voltage-controlled device that is used as a switching element in power supply circuits and motor drives, amongst other systems. The gate is the electrically insulated control terminal for each device. The other terminals of a MOSFET are source and drain, and for an IGBT the other terminals are called collector and emitter. To operate a MOSFET/IGBT, a voltage is applied to the gate that is relative to the source/emitter of the device. Dedicated drivers are used to apply voltage and provide drive current to the gate of the power device.

For operating an IGBT/power MOSFET as a switch, a voltage sufficiently larger than the gate threshold voltage should be applied between the gate and source/emitter terminals. A gate driver may be supplied to convert a low-power input from a microcontroller into a high-current drive input for the gate of a high-power transistor such as an IGBT or power MOSFET.

For a system using gate drivers, galvanic isolation may be necessary for functional purposes and it might also be a safety requirement. In particular, galvanic isolation may be a requirement between the high power side and low voltage control circuit if there is any human involvement on the control side. The isolation also protects low voltage electronics from any damage due to faults on the high power side. In one example, an isolated gate driver circuit may employ capacitive structures to supply galvanic isolation from a controller side (Low voltage) to high power switch side (high voltage).

A parameter of interest for operation of an isolated gate driver for high frequency operation is the common-mode transient immunity (CMTI). CMTI may refer to the maximum tolerable rate of rise or fall of the common mode voltage applied between two isolated circuits. The unit is normally represented as kV/us or V/ns. A relatively higher CMTI means that the two isolated circuits, both transmitter side and receiver side, function relatively better without error when striking the isolation barrier with very high rise slew rate, or high fall slew rate.

Recently wide band gap (WBG) semiconductors have attracted increasing attention for use as power transistors, including SiC, GaN, and other known WBG materials. These materials enable faster switching speed in comparison to silicon, for example. In particular, fast switching on the order of 3 ns or less is possible in the context of an isolated gate driver circuit. This fast switching generates disturbances through the isolation barrier, thus compromising gate driver operation. In particular, to switch from 0 to 1000 V in 3 ns, a CMTI of at least 300 kV/ms may be called for, which capability may not be readily provided in present day gate driver circuits. Moreover, for higher voltage switching, even higher CMTI may be required.

In view of the above, the present disclosure is provided.

### Brief Summary

In one embodiment, an isolation circuit arrangement is provided. As such, the isolation circuit arrangement may include an isolation barrier and may be configured to receive one or more input signals on a low voltage side and deliver one or more output signals on a high voltage side. The isolation barrier may include a first capacitor, arranged along a first input line, and a second capacitor arranged along a second input line, in electrically parallel fashion to the first capacitor. The isolation barrier may also include a first inductor having a first end that is coupled to a first electrode of the first capacitor and having a second end that is coupled to a first electrode of the second capacitor. The isolation barrier may further include a center tap, connected to the first inductor, and a second inductor that is inductively coupled to the first inductor and is arranged with a first output end and a second output end on a high voltage side of the isolation circuit arrangement.

In another embodiment, a gate driver arrangement is provided. The gate driver arrangement may include a signal source to generate one or more control signals, and an isolation barrier, to receive the one or more control signals, the isolation barrier comprising an isolation circuit. The isolation circuit may include a first capacitor, arranged along a first input line, and a second capacitor arranged along a second input line, in electrically parallel fashion to the first capacitor. The isolation circuit may also include a first inductor having a first end that is coupled to the first capacitor and having a second end that is coupled to the second capacitor. The isolation circuit may further include a center tap, connected to the first inductor, and a second inductor that is inductively coupled to the first inductor and is arranged with a first output end and a second output end on a high voltage side of the gate driver arrangement.

In a further embodiment, a gate driver arrangement is provided, including a signal source to generate one or more control signals, and an isolation barrier, to receive the one or more control signals. The isolation barrier may have an isolation circuit, where the isolation circuit includes a first capacitor, arranged along a first input line, and a second capacitor arranged along a second input line, in electrically parallel fashion to the first capacitor. The isolation barrier may also include a first inductor having a first end that is coupled to the first capacitor and having a second end that is coupled to the second capacitor. The isolation barrier may further include a grounded center tap, connected to the first inductor, and a second inductor that is inductively coupled to the first inductor and is arranged with a first output end and a second output end on a high voltage side of the gate driver arrangement. The gate driver arrangement may also include a demodulator, coupled to the second inductor, and a gate driver, coupled to demodulator, and arranged to output a drive signal to a gate of a power switch.

### Brief Description of the Drawings

**FIG. 1A** illustrates a gate driver arrangement according to embodiments of the disclosure;
**FIG. 1B** illustrates another gate driver arrangement according to embodiments of the disclosure;
**FIG. 2A** shows one instance of operation of the arrangement of FIG. 1;
**FIG. 2B** illustrates details of a common-mode voltage pulse;
**FIG.** 3 shows a top view of an isolation chip, according to some embodiments of the disclosure;
**FIG. 4** depicts another gate driver arrangement, according to further embodiments of the disclosure;
**FIG. 5A** depicts an isolation circuit arrangement, according to further embodiments of the disclosure;
**FIG. 5B** shows an image of an embodiment of the connection between isolation circuits of FIG. 5A;
**FIG. 6** depicts an isolation circuit arrangement, according to additional embodiments of the disclosure;
**FIG. 7** depicts an isolation circuit arrangement, according to additional embodiments of the disclosure;
**FIG. 8** depicts an isolation circuit arrangement, according to additional embodiments of the disclosure; and
**FIG. 9** illustrates an isolation circuit arrangement according to further embodiments of the disclosure.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

In various embodiments, systems, devices, and techniques are provided for isolated gate driver circuits. According to some embodiments, as described hereinbelow, circuitry is disclosed to provide illustration of functional equivalents for implementing an isolated gate driver circuit, where the details of actual components, and circuit arrangements for implementing the gate drive signal may vary, as will be understood by those of ordinary skill in the art.

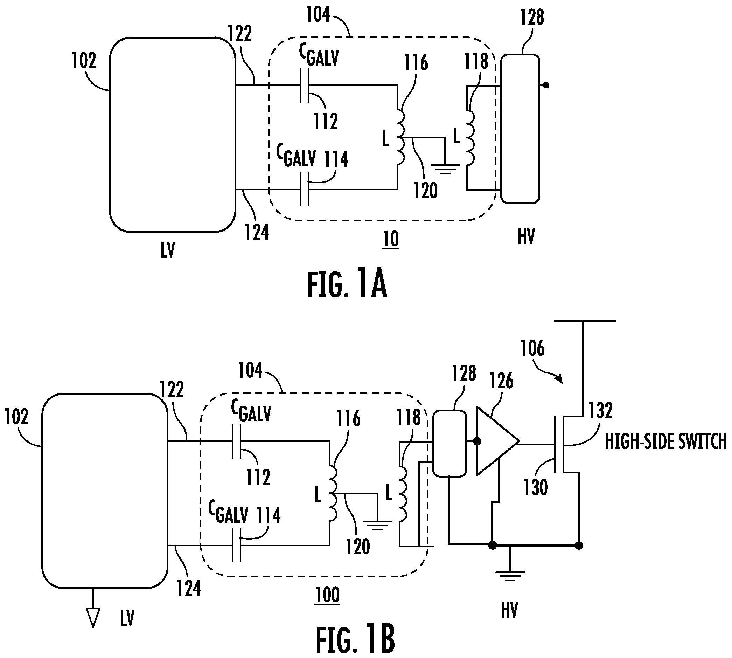

Turning to **FIG. 1A** there is shown an isolation circuit arrangement 10 according to some embodiments of the disclosure. The isolation circuit arrangement 10 implements an isolation function for providing galvanic isolation between a signal source located on a low voltage (LV) side of the isolation circuit arrangement 10. The signal source 102 may be a microcontroller to output a control signal that is used to control the gate of a power switch located on the HV side of the isolation circuit arrangement 10, for example.

As further shown in FIG. 1A, the isolation circuit arrangement 10 includes an isolation circuit 104. This circuit may function as an isolation barrier to provide galvanic isolation between the signal source 102 and other circuitry operating at low voltage, and circuitry operating at the high voltage (HV) side of the isolation circuit arrangement 10.

The isolation circuit 104 includes a novel arrangement of capacitive and inductive elements that provide a galvanic isolation between the low voltage (LV) side and HV side in the isolation circuit arrangement 10. As depicted in FIG.1A, the isolation circuit 104 may include a first capacitor 112, arranged along a first input line 122, and a second capacitor 114 arranged along a second input line124. The second capacitor 114 is arranged in electrically parallel fashion to the first capacitor 112. In various embodiments, the first capacitor 112 and second capacitor 114 may be arranged to have the same capacitance.

The isolation circuit 104 may further include an inductive circuit that is arranged, for example, like a coreless transformer with a first and second inductor. As shown in FIG. 1A, a first inductor 116 is provided having a first end that is coupled to the first capacitor 112 and having a second end that is coupled to the second capacitor 114. A second inductor 118 is provided that is inductively coupled to the first inductor 116 and is arranged to couple to component such as a demodulator 128.

In various non-limiting embodiments, the isolation circuit 104 may be arranged in a semiconductor chip that may be a standalone chip that is separate from the signal source 102, while in other embodiments the isolation circuit 104 may be integrated on the same chip as the signal source 102. Likewise, in some embodiments the isolation circuit may be provided on a chip that is separate from a component on the HV side, such as a demodulator 128, while in other embodiments, the isolation circuit 104 may be integrated on a same chip as other components on the HV side, such as a demodulator 128.

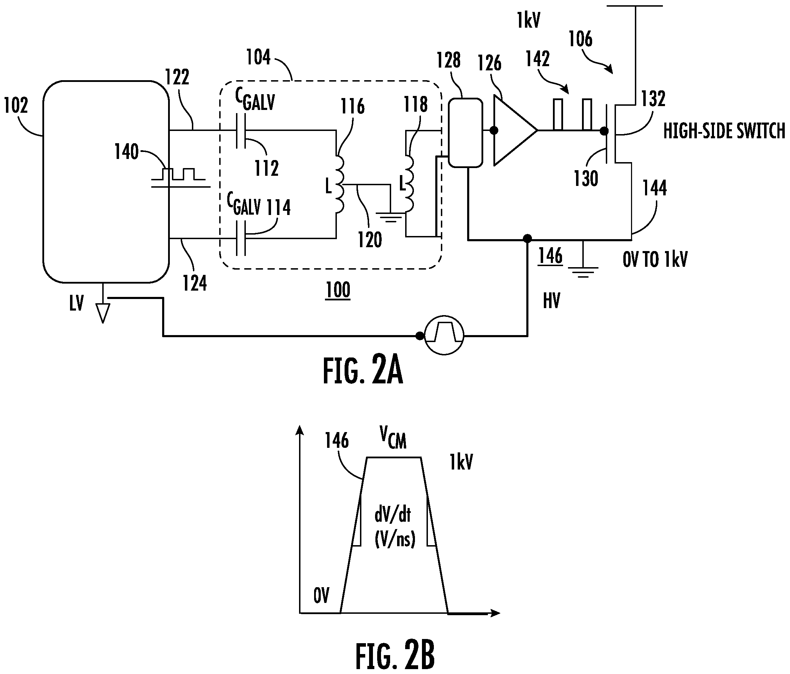

Turning to **FIG. 1B** there is shown an isolation circuit arrangement 100 according to some embodiments of the disclosure. The isolation circuit arrangement 100 implements an isolated gate driver function for controlling operation of power switching circuitry 106. The power switching circuitry may be implemented using known power transistors, such as IGBTs or power MOSFETs. In any case, the isolation circuit arrangement is structured so as to provide a control signal to a gate of the power transistor of power switching circuitry 106. In some examples, voltage across the main terminals of a high side switch of the power switching circuitry 106 may be up to 1 kV or greater. The isolation circuit arrangement 100 may include a drive signal source, shown as signal source 102, such as a microcontroller to output a gate driver signal that is used to control the gate of the power switching circuitry 106. This signal source 102 may operate on a low voltage side of the isolation circuit arrangement 100. As such, the signal source 102 may output a series of drive pulses that cause to power switching circuitry 106 to output a series of voltage pulses that have an amplitude corresponding to the maximum voltage crossing the power switching circuitry 106, as explained in more detail with respect to FIGs. 2A and 2B to follow.

As further shown in FIG. 1B, the isolation circuit arrangement 100 includes an isolation circuit 104. This circuit is arranged to provide galvanic isolation between the signal source 102 and other circuitry operating at low voltage, and the power switching circuitry 106, operating at the high voltage (HV) side of the isolation circuit arrangement 100.

The isolation circuit 104 includes a novel arrangement of capacitive and inductive elements that provide a galvanic isolation between the low voltage (LV) side and HV side in the isolation circuit arrangement 100. As depicted in FIG.1B, the isolation circuit 104 may include a first capacitor 112, arranged along a first input line 122, and a second capacitor 114 arranged along a second input line124. The second capacitor 114 is arranged in electrically parallel fashion to the first capacitor 112. In various embodiments, the first capacitor 112 and second capacitor 114 may be arranged to have the same capacitance.

The isolation circuit 104 may further include an inductive circuit that is arranged, for example, like a coreless transformer with a first and second inductor. As shown in FIG. 1B, a first inductor 116 is provided having a first end that is coupled to the first capacitor 112 and having a second end that is coupled to the second capacitor 114. A second inductor 118 is provided that is inductively coupled to the first inductor 116 and is arranged with a first output end that is to electrically couple to a demodulator 128. An output of the demodulator 128 connects to gate driver for a gate terminal 130 of a power switch 132. The second end of the second inductor 118 may be coupled to a low voltage side of the power switch 132, via demodulator 128, as shown.

In various non-limiting embodiments, the isolation circuit 104 may be arranged in a semiconductor chip that may be a standalone chip that is separate from the signal source 102 and the power switch 132. For example, the isolation circuit 104 may be formed in a semiconductor chip based in a silicon substrate in some embodiments. On the other hand, the power switch 132 may be embodied in another semiconductor substrate, such as a GaN substrate, a SiC substrate, or a silicon substrate, according to different embodiments. In the example shown, the isolation circuit arrangement 100 may include a demodulator 128 and gate driver circuit 126, both components being arranged on the high voltage (HV) side.

**FIG. 2A** shows one instance of operation of the arrangement of FIG. 1B. In order to control operation of the power switch 132, the signal source 102 may be arranged to output a control signal 140 that is ultimately used to switch the gate terminal 130 of the power switch 132 from an ON state to an OFF state, and to thus drive a current/voltage pulse through the power switch 132. As an example, the signal source 102 may be arranged to generate the control signal 140 as a pulse width modulated pulse train. After passing through the isolation circuit 104, and demodulator 128, a resulting gate signal 142 may be generated by the gate driver circuit 126 to control opening and closing of the gate terminal 130.

To explain the advantages of the isolation circuit 104, it is noted that in known isolated gate driver circuits, based on capacitive isolation, for example, the gate driver may be referenced to the switching node 144 of the power switch 132. In such conventional circuits, as the power switch transitions between ON state and OFF state, a voltage signal 146, also shown as V_{CM}, will develop, as shown in **FIG. 2B****.** Depending upon the magnitude of voltage and the switching speed the slope of the voltage signal, or the value of dV/dt may be on the order of 100 kV/ms, 300 kV/ms, 500 kV/ms or 1000 kV/ms, or greater. This common mode transient voltage may propagate through the isolation barrier in known isolation circuits, compromising gate driver operation. In contrast, while the isolation circuit 104 also provides galvanic isolation via the first capacitor 112 and the second capacitor 114, as in known gate drivers, the isolation circuit 104 provides immunity to common mode transients. This result is particularly due to the arrangement of the first inductor 116 and the second inductor 118, in a transformer configuration, with a center tap 120 provided for current discharge.

In principle, the configuration of the isolation circuit 104 may provide a protection equivalent to a relatively higher value of CMTI, such as greater than CMTI of at least 100 kV/ms, at least 200 kV/ms or greater than 300 kV/ms. Thus, if the power switching circuity 106 is embodied in a HBG chip, such as GaN or SiC, even if the HBG chip operates at switching speeds of ~ 1 ns, the circuitry of the isolation circuit arrangement 100, including that circuitry on the low voltage side, will be protected from common mode transients that may otherwise cross the isolation barrier, thus ensuring operation without such noise. In particular, the provision of ground connection for the center tap 120 provides a path to redirect current caused in CMT events directly to ground, so that circuitries such as the demodulator 128 do not experience in the CMT. Note that in optional embodiments the center tap need not be grounded, in which case CMT immunity may not be as pronounced as in the case of a grounded center tap. In some variants of the embodiment of FIG. 2B, the first inductor 116, the second inductor 118, and center tap 120 may be arranged in a symmetrical transformer configuration so as to avoid the generation of any common mode signals due to transformer asymmetry.

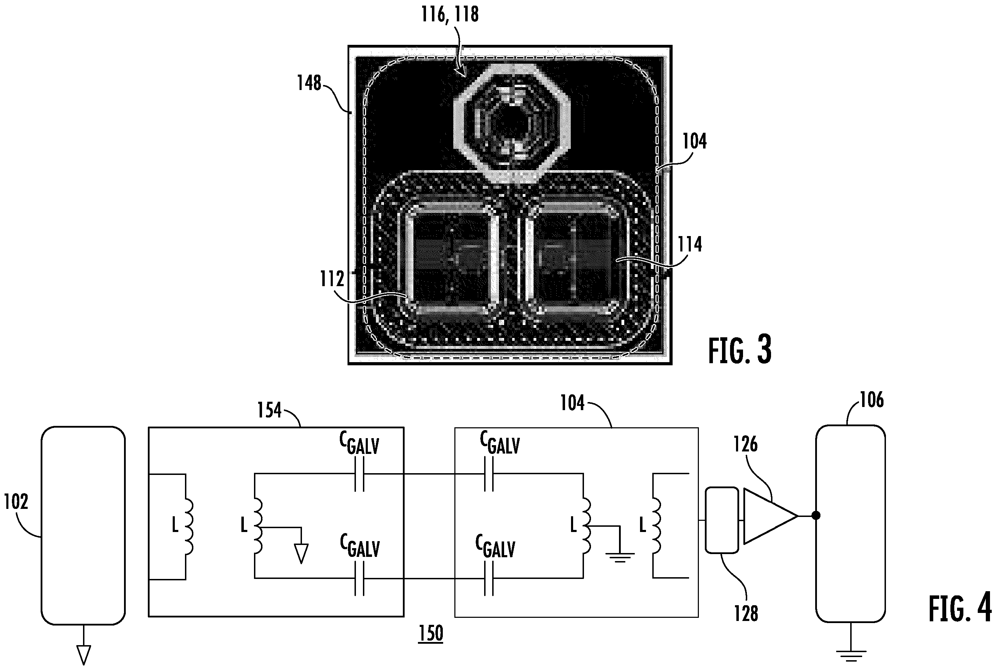

**FIG. 3** shows a top view of an isolation chip 148, according to some embodiments of the disclosure. In this example, the isolation circuit 104 may be embedded in the isolation chip 148, which chip may be formed in any suitable semiconductor substrate, such as silicon. In this embodiment, the first capacitor 112 and second capacitor 114 of the isolation circuit 104 are arranged as a parallel plate structure where a pair of electrodes (only the top electrode is visible) are arranged in planar fashion along a main plane of the semiconductor chip. Note that the first capacitor 112 and the second capacitor 114 are arranged symmetrically within the isolation chip 148, and have a somewhat rectangular shape. However, according to various embodiments of the disclosure the first capacitor 112 and second capacitor 114 may have any suitable shape and arrangement.

In this embodiment, the first inductor 116 and second inductor 118 of the isolation circuit 104 are also arranged in a planar structure along the main plane of the isolation chip 148. The first inductor 116 may be disposed in an interleaved fashion with the second inductor 118, according to some embodiments. Note that exact shape of the first inductor 116 and second inductor 118 may vary according to different embodiments.

**FIG. 4** depicts another isolation circuit arrangement, according to further embodiments of the disclosure. In this example, the isolation circuit arrangement 150 may include components similar to the embodiment of FIG. 1, where like components are labeled the same. In this example an isolation circuit function is provided by two parts, including a first isolation circuit that is represented by isolation circuit 104, described previously, and a second isolation circuit, represented by the isolation circuit 154. As illustrated, the isolation circuit 104 and the isolation circuit 154 are arranged in electrical series with one another. With reference to the components of isolation circuit 104, described previously, each of these circuits may include a first capacitor and a second capacitor arranged in electrically parallel fashion to the first capacitor, as well as a first inductor and a second inductor, where the first inductor has a first end that is coupled to the first capacitor and a second end that is coupled to the second capacitor. The first inductor is also provided with a center tap as shown.

Note that in this configuration, the first capacitor of the isolation circuit 104 is electrically conductively connected to the first capacitor of the second isolation circuit, meaning the isolation circuit 154 , and the second capacitor of the isolation circuit 104 is electrically conductively connected to the second capacitor of the second isolation circuit. According to various embodiments of the disclosure, the isolation circuit 104 may be arranged in a first semiconductor chip, while the isolation circuit 154 is arranged in a second semiconductor chip.

In operation of the isolation circuit arrangement 150, each transformer part directs one polarity of the CMT current: one center tap is used for positive slope CMTI event the other center tap is used for the negative slope CMTI event. The splitting of the capacitor part allows implementing the isolation circuit arrangement 150 in two different chips. Note also that the ground domain in the isolation circuit 104 is different from the ground domain of the isolation circuit 154, as indicated.

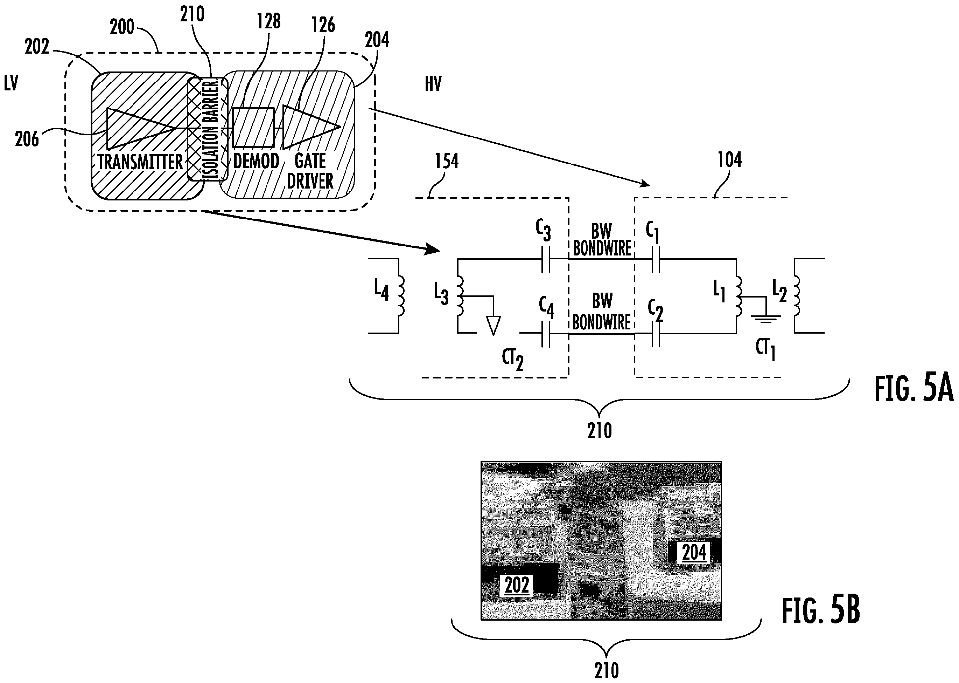

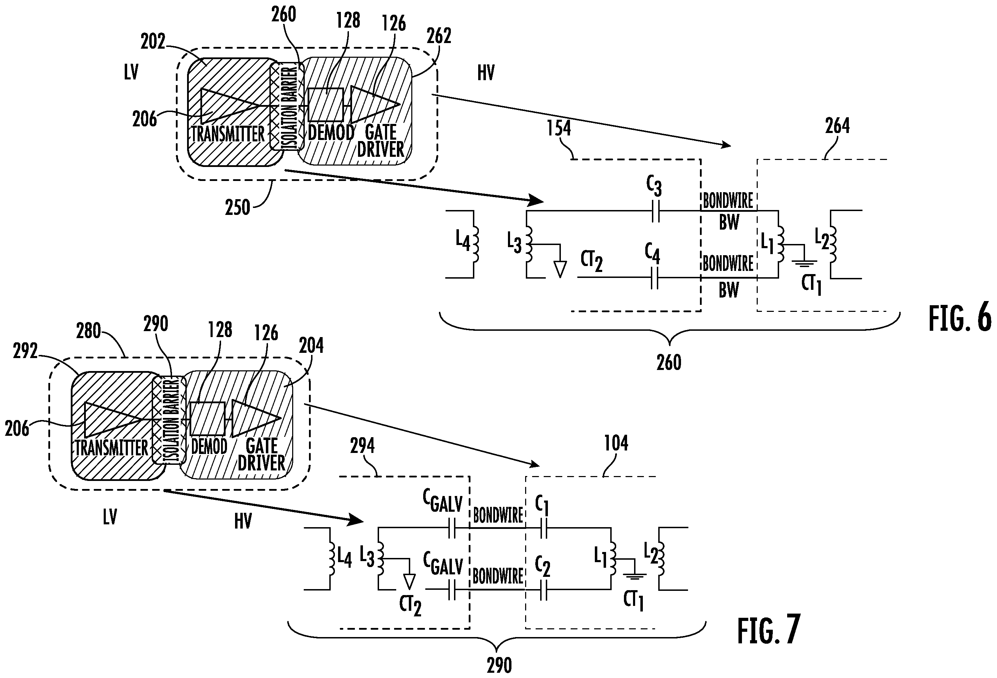

**FIG. 5A** depicts an isolation circuit arrangement 200, according to further embodiments of the disclosure. The isolation circuit arrangement 200 in this embodiment and in embodiments disclosed in FIGs. 6-8 may be used, for example, as gate driver arrangement for controlling switches on a high voltage side of an isolation barrier, where the switches are gated semiconductor devices, such as MOSFETs or IGBTs. The isolation circuit arrangement 200 may be implemented in a package that includes two semiconductor chips, according to some embodiments. In operation, the isolation circuit arrangement 200 may be used to couple a signal source that operates on a low voltage (LV) side to a component on a high voltage side (HV), such as a switch, described previously. As such, the isolation circuit arrangement 200 may provide galvanic isolation between the LV side and HV side, and may further provide enhanced CMTI, as described previously. In the example shown, the isolation circuit arrangement 200 includes a first chip 202 and a second chip 204, which components may be arranged in a common package, as noted. In this embodiment, an isolation barrier 210 is distributed between the first chip 202 and the second chip 204. In one example, the first chip 202 may include transmitter circuitry 206, while the second chip 204 includes a demodulator 128 and gate driver circuit 126. In the example shown, the first chip 202 may include the isolation circuit 154, while the second chip 204 includes the isolation circuit 104, as described previously. Note that the isolation circuit 154 may be arranged on a periphery of the first chip 202, while the isolation circuit 104 is arranged on a periphery of the second chip 204. The isolation circuit 154 may be connected to the isolation circuit 104 using any suitable conductive connector, such as bond wires (BW), which wires may extend from electrodes of each of the capacitors of the isolation barrier 210. An image of an embodiment of the connection between isolation circuit 154 and isolation circuit 104 is shown in **FIG. 5B****.** Thus, the capacitor C1 of isolation circuit 104 is connected through a bond wire to the capacitor C3 of isolation circuit 154, while the capacitor C2 of isolation circuit 104 is connected through a bond wire to the capacitor C4 of isolation circuit 154. Together, the isolation circuit 104, isolation circuit 154 and bondwires BW form the isolation barrier 210, which arrangement provides galvanic isolation as well as enhanced CMTI. Note also that the ground domain in the isolation circuit 104 is different from the ground domain of the isolation circuit 154, as indicated.

**FIG. 6** depicts an isolation circuit arrangement 250, according to additional embodiments of the disclosure. The isolation circuit arrangement 250 may be implemented in a package that includes two semiconductor chips, according to some embodiments. In operation, the isolation circuit arrangement 250 may be used to couple a signal source that operates on a low voltage (LV) side to a component on a high voltage side (HV), such as a switch, described previously. As such, the isolation circuit arrangement 250 may provide galvanic isolation between the LV side and HV side, and may further provide enhanced CMTI, as described previously. In the example shown, the isolation circuit arrangement 250 includes a first chip 202 and a second chip 262, which components may be arranged in a common package, as noted. In this embodiment, an isolation barrier 260 is distributed between the first chip 202 and the second chip 262. In one example, the first chip 202 may include transmitter circuitry 206, while the second chip 262 includes the demodulator 128 and gate driver circuit 126. In the example shown, the first chip 202 may include the isolation circuit 154, while the second chip 262 includes an isolation circuit 264. Note that the isolation circuit 154 may be arranged on a periphery of the first chip 202, while the isolation circuit 264 is arranged on a periphery of the second chip 262. The isolation circuit 154 may be connected to the isolation circuit 264 using any suitable conductive connector, such as bond wires (BW), which wires may extend from electrodes of each of the capacitors of the isolation barrier 260, generally as described above with respect to FIG. 5A and FIG. 5B. In this case, the capacitor electrode is connected through bondwire to the inductor electrode Together, the isolation circuit 104, isolation circuit 264 and bondwires BW form the isolation barrier 260, which arrangement provides galvanic isolation as well as enhanced CMTI. In this embodiment, the isolation circuit 264 includes a first inductor L1 and a second inductor L2, but does not include a set of capacitors Thus, the galvanic isolation of the isolation barrier 260 is provided by the capacitors C3 and capacitor C4 in the isolation circuit 154. Note also that the ground domain in the isolation circuit 154 is different from the ground domain of the isolation circuit 264, as indicated.

**FIG. 7** depicts an isolation circuit arrangement 280, according to additional embodiments of the disclosure. The isolation circuit arrangement 280 may be implemented in a package that includes two semiconductor chips, according to some embodiments. In operation, the isolation circuit arrangement 280 may be used to couple a signal source that operates on a low voltage (LV) side to a component on a high voltage side (HV), such as a switch, described previously. As such, the isolation circuit arrangement 280 may provide galvanic isolation between the LV side and HV side, and may further provide enhanced CMTI, as described previously. In the example shown, the isolation circuit arrangement 280 includes a first chip 292 and a second chip 204, which components may be arranged in a common package, as noted. In this embodiment, an isolation barrier 290 is distributed between the first chip 292 and the second chip 204. In one example, the first chip 292 may include transmitter circuitry 206, while the second chip 204 includes the demodulator 128 and gate driver circuit 126. In the example shown, the first chip 292 may include an isolation circuit 294, while the second chip 204 includes an isolation circuit 104, described previously. Note that the isolation circuit 294 may be arranged on a periphery of the first chip 292, while the isolation circuit 104 is arranged on a periphery of the second chip 204. The isolation circuit 294 may be connected to the isolation circuit 104 using any suitable conductive connector, such as bond wires (BW), which wires may extend from electrodes of each of the capacitors of the isolation barrier 290, generally as described above with respect to FIG. 5A and FIG. 5B. In this case, the capacitor electrode is connected through bondwire to the inductor electrode. Together, the isolation circuit 104, isolation circuit 294 and bondwires BW form the isolation barrier 290, which arrangement provides galvanic isolation as well as enhanced CMTI. In this embodiment, the isolation circuit 294 includes a first inductor L1 and a second inductor L2, but does not include a set of capacitors Thus, the galvanic isolation of the isolation barrier 290 is provided by the capacitors C1 and capacitor C2 in the isolation circuit 104. Note also that the ground domain in the isolation circuit 104 is different from the ground domain of the isolation circuit 294, as indicated.

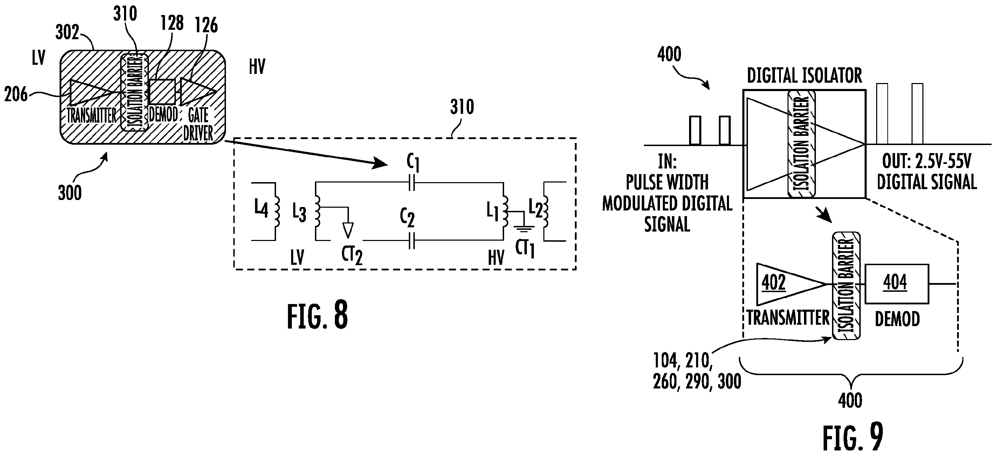

**FIG. 8** depicts an isolation circuit arrangement 300, according to additional embodiments of the disclosure. The isolation circuit arrangement 300 may be implemented in a package that includes a single semiconductor chip, shown as chip 302, according to some embodiments. In operation, the isolation circuit arrangement 300 may be used to couple a signal source that operates on a low voltage (LV) side to a component on a high voltage side (HV), such as a switch, described previously. As such, the isolation circuit arrangement 300 may provide galvanic isolation between the LV side and HV side, and may further provide enhanced CMTI, as described previously. In the example shown, the isolation circuit arrangement 300 includes a chip 302, which component may be arranged in a package that couples components on the HV side to components on the LV side. In one example, the chip 302 may include transmitter circuitry 206, the demodulator 128 and gate driver circuit 126. In the example shown, the chip 302 may include an isolation barrier 310. The isolation barrier 310 provides galvanic isolation as well as enhanced CMTI. In this embodiment, the isolation barrier 310 includes a first inductor L1 and a second inductor L2, arranged on an HV side, and a third inductor L3 and fourth inductor L4, arranged on the LV side. A single set of capacitors is provided in the isolation circuit, shown as capacitor C1 and capacitor C2, providing the galvanic isolation of the isolation barrier 310. Note that for implementation in a single semiconductor chip, an insulation means is called for within the semiconductor substrate, such as a silicon-on-insulator (SOI) architecture. Note also that the ground domain differs between the two different center taps, CT1 and CT2, as shown.

**FIG.** 9 illustrates an isolation circuit arrangement 400 according to further embodiments of the disclosure. The isolation circuit arrangement 400 may be implemented as a digital isolator for such applications as isolating communication interfaces. In this embodiment, an isolation barrier, such as any of the isolation barriers of the aforementioned embodiments, may be arranged between a transmitter 402 on the LV side and a demodulator 404 on the HV side.
While the present embodiments have been disclosed with reference to certain embodiments, numerous modifications, alterations and changes to the described embodiments are possible while not departing from the sphere and scope of the present disclosure, as defined in the appended claims. Accordingly, the present embodiments are not to be limited to the described embodiments, and may have the full scope defined by the language of the following claims, and equivalents thereof.

## Claims

1. An isolation circuit arrangement, configured to receive one or more input signals on a low voltage side and deliver one or more output signals on a high voltage side, the isolation circuit arrangement comprising an isolation barrier, comprising:
a first capacitor, arranged along a first input line;
a second capacitor arranged along a second input line, in electrically parallel fashion to the first capacitor;
a first inductor having a first end that is coupled to a first electrode of the first capacitor and having a second end that is coupled to a first electrode of the second capacitor;
a center tap, connected to the first inductor; and
a second inductor that is inductively coupled to the first inductor and is arranged with a first output end and a second output end on a high voltage side of the isolation circuit arrangement.

2. The isolation circuit arrangement of claim 1, wherein the isolation barrier is arranged in a single semiconductor chip.

3. The isolation circuit arrangement of 1 or 2, the isolation circuit further comprising:
a third inductor having a first end that is coupled to the first capacitor and having a second end that is coupled to the second capacitor;
a center tap, connected to the third inductor; and
a fourth inductor that is inductively coupled to the third inductor and is arranged with a first input end and a second input end on a low voltage side of the isolation circuit arrangement.

4. The isolation circuit arrangement of any of the preceding claims, wherein the first capacitor, second capacitor, first inductor and second inductor are arranged in a first isolation circuit, wherein a second isolation circuit is disposed in the isolation circuit arrangement, the second isolation circuit comprising:
a third capacitor, connected to the first capacitor;
a fourth capacitor connected to the second capacitor;
a third inductor having a first end that is coupled to the third capacitor and having a second end that is coupled to the fourth capacitor; and
a fourth inductor that is inductively coupled to the third inductor and is arranged with a first input end and a second input end on a low voltage side of the isolation circuit arrangement.

5. The isolation circuit arrangement of claim 4, wherein the first isolation circuit and the second isolation circuit together form an isolation barrier, wherein the first isolation circuit is disposed in a first semiconductor chip, the second isolation circuit is disposed in a second semiconductor chip, and wherein the first isolation circuit is connected to the second isolation circuit via a pair of conductive connectors, preferably wherein the first semiconductor chip further comprises a transmitter, and the second semiconductor chip further comprising a demodulator and a gate driver.

6. The isolation circuit arrangement of claim 1, further comprising an inductor circuit, comprising:
a third inductor having a first end that is coupled to a second electrode of the first capacitor and having a second end that is coupled to a second end of the second capacitor
a center tap, connected to the third inductor; and
a fourth inductor that is inductively coupled to the third inductor and is arranged with a first input end and a second input end on a low voltage side of the isolation circuit arrangement.

7. The isolation circuit arrangement of claim 6, with one or more of the following:
- wherein the inductor circuit and the first capacitor and second capacitor are disposed in a first semiconductor chip, and wherein the first inductor and second inductor are disposed in a second semiconductor chip;
- wherein the first capacitor, second capacitor, first inductor and second inductor are arranged in a first isolation circuit, wherein the first isolation circuit is arranged in a first chip, and wherein the inductor circuit is arranged in a second semiconductor chip;
- wherein the first capacitor, second capacitor, first inductor, second inductor and the inductor circuit are arranged together in one semiconductor chip., wherein the one semiconductor chip is a silicon-on-insulator chip.

8. A gate driver arrangement:
a signal source to generate one or more control signals;
an isolation barrier, to receive the one or more control signals, the isolation barrier comprising an isolation circuit according to claim 1.

9. The gate driver arrangement of claim 8, further comprising:
a demodulator, arranged on the high voltage side; and
a gate driver, coupled to the demodulator, and arranged to output a gate drive signal to a high side switch.

10. The gate driver arrangement of claim 8 or 9, the isolation barrier further comprising:
a third inductor having a first end that is coupled to the first capacitor and having a second end that is coupled to the second capacitor;
a center tap, connected to the third inductor; and
a fourth inductor that is inductively coupled to the third inductor and is arranged with a first input end and a second input end on a low voltage side of the gate driver arrangement.

11. The gate driver arrangement of claim 10, with one or more of the following:
- wherein the third inductor, fourth inductor, the first capacitor and second capacitor are disposed in a first semiconductor chip, and wherein the first inductor and second inductor are disposed in a second semiconductor chip;
- wherein the first capacitor, second capacitor, first inductor and second inductor are arranged in a first isolation circuit, wherein the first isolation circuit is arranged in a first chip, and wherein the third inductor and the fourth inductor are arranged in a second semiconductor chip;
- wherein the isolation barrier is arranged in a single semiconductor chip.

12. The gate driver arrangement of any of the claims 8-11, wherein the first capacitor, second capacitor, first inductor and second inductor are arranged in a first isolation circuit, wherein a second isolation circuit is disposed in the isolation barrier, the second isolation circuit comprising:
a third capacitor, connected to the first capacitor;
a fourth capacitor connected to the second capacitor;
a third inductor having a first end that is coupled to the third capacitor and having a second end that is coupled to the fourth capacitor; and
a fourth inductor that is inductively coupled to the third inductor and is arranged with a first input end and a second input end on a low voltage side of the gate driver arrangement.

13. The gate driver arrangement of claim 12, wherein the first isolation circuit is disposed in a first semiconductor chip, the second isolation circuit is disposed in a second semiconductor chip, and wherein the first isolation circuit is connected to the second isolation circuit via a pair of bond wires.

14. The gate driver arrangement of claim 13, the first semiconductor chip further comprising a transmitter, and the second semiconductor chip further comprising a demodulator and a gate driver.

15. The gate driver arrangement according to any of the claims 8-14, wherein the center tap is grounded.
